# EUROPEAN PATENT APPLICATION

(11) **EP 2 408 008 A1**
(43) Date of publication of application: **18.01.2012**
(21) Application number: 10750657.8
(22) Date of filing: 19.02.2010
(51) Int. Cl.: H01L 23/10, C09J 7/02, G03F 7/09, H01L 27/14

(54) **FILM FOR SPACER FORMATION, SEMICONDUCTOR WAFER, AND SEMICONDUCTOR DEVICE**

(30) Priority: 12.03.2009 JP 2009060303
(71) Applicant: Sumitomo Bakelite Company Limited, Shinagawa-ku Tokyo 140-0002 (JP)
(72) Inventor: SHIRAISHI Fumihiro, Tokyo 140-0002 (JP); KAWATA Masakazu, Tokyo 140-0002 (JP); YONEYAMA Masahiro, Tokyo 140-0002 (JP); TAKAHASHI Toyosei, Tokyo 140-0002 (JP); DEJIMA Hirohisa, Tokyo 140-0002 (JP); SATO Toshihiro, Tokyo 140-0002 (JP)
(74) Representative: Solf, Alexander
(86) International application number: PCT/JP2010/052503
(87) International publication number: WO 2010/103903

(57) **Abstract**

A spacer formation film is adapted to be used for forming a spacer defining air-gap portions on a side of one surface of a semiconductor wafer and by being cut into a desired shape, the spacer formation film includes: a support base having a sheet-like shape; a spacer formation layer provided on the support base and having a bonding property, the spacer formation layer formed of a material containing an alkali soluble resin, a thermosetting resin and a photo polymerization initiator; and a cutting line along which the spacer formation film is to be cut, wherein the spacer formation layer is provided inside the cutting line so that a peripheral edge thereof is not overlapped to the cutting line.

## Description

### TECHNICAL FIELD

The present invention relates to a spacer formation film, a semiconductor wafer and a semiconductor device.

### RELATED ART

Semiconductor devices represented by a CMOS sensor, a CCD sensor and the like are known. In general, such a semiconductor device includes a semiconductor substrate provided with a light receiving portion, a spacer provided on the semiconductor substrate and formed so as to surround the light receiving portion, and a transparent substrate bonded to the semiconductor substrate via the spacer.

Recently, in manufacturing such semiconductor devices, in order to improve productivity thereof, an effort of forming the above spacer using a photosensitive film (spacer formation film) is carried out (see, for example, Patent Document 1). This photosensitive film is used by being attached to a semiconductor wafer, and then the film is patterned by being exposed and developed. Thereafter, a transparent substrate made of glass or the like is bonded to the patterned film (spacer).

Such a photosensitive film has a sheet base and a bonding layer (spacer formation layer), and the bonding layer is generally provided on the entire surface of the sheet base. In manufacturing the semiconductor device, the photosensitive film is cut so as to have the same size as the semiconductor wafer, and then the cut photosensitive film is attached to the semiconductor wafer.

However, in the conventional photosensitive film, since the bonding layer is provided on the entire surface of the sheet base, there is a problem in that a part of the bonding layer adheres to a blade used for cutting the film. The adhesive matters remaining on the blade are often transferred to the vicinity of a peripheral edge of the subsequent photosensitive film when cutting it. This causes adhesion of the adhesive matters on a surface of the photosensitive film when it is attached to the semiconductor wafer. In this case, the adhesive matters adhering on the surface prevent the bonding layer from being exposed during the exposure, and therefore the bonding layer cannot be patterned at sufficient accuracy. This causes another problem of lowering productivity of semiconductor devices.

The Patent Document 1 is Japanese Patent Application Laid-open No. 2006-323089.

### SUMMARY OF THE INVENTION

It is an object of the present invention to provide a spacer formation film having an excellent patterning property during exposure and superior productivity of semiconductor devices by making it difficult for a part of a spacer formation film to adhere to a blade to be used for cutting it, and to provide a semiconductor wafer having excellent productivity of semiconductor devices and a semiconductor device manufactured using such a semiconductor wafer.

In order to achieve such an object, the present invention includes the following features (1) to (9).
(1) A spacer formation film adapted to be used for forming a spacer defining air-gap portions on a side of one surface of a semiconductor wafer and by being cut into a desired shape, the spacer formation film comprising:
   a support base having a sheet-like shape;
   a spacer formation layer provided on the support base and having a bonding property, the spacer formation layer formed of a material containing an alkali soluble resin, a thermosetting resin and a photo polymerization initiator; and
   a cutting line along which the spacer formation film is to be cut,
   wherein the spacer formation layer is provided inside the cutting line so that a peripheral edge thereof is not overlapped to the cutting line.

(2) The spacer formation film according to the above feature (1), wherein a planar shape of the spacer formation layer is a substantially circular shape having a diameter of "X",
wherein the cutting line is of a substantially circular shape having a diameter of "Y" and is concentrically arranged with respect to a circle defined by the peripheral edge of the spacer formation layer, and
wherein X and Y satisfy a relation of 0.80 ≤ X/Y <1.00.

(3) The spacer formation film according to the above feature (1), wherein the cutting line is of a substantially circular shape, and
wherein in the case where a diameter of a circle defined by the cutting line is "Y (cm)" and a diameter of the semiconductor wafer, to which the spacer formation layer is to be attached, is "Z (cm)", Y and Z satisfy a relation of 0.85 ≤ Y/Z ≤1.15.

(4) The spacer formation film according to the above feature (1), wherein a planar shape of the spacer formation layer is a substantially circular shape having a diameter of "X", and
wherein in the case where a diameter of the semiconductor wafer, to which the spacer formation layer is to be attached, is "Z (cm)", X and Z satisfy a relation of 0.80 ≤ X/Z <1.00.

(5) The spacer formation film according to the above feature (1), wherein in a position where the peripheral edge of the spacer formation layer is closest to the cutting line, a distance between the peripheral edge of the spacer formation layer and the cutting line is in the range of 10 to 20,000 µm.

(6) The spacer formation film according to the above feature (1), wherein an average thickness of the spacer formation layer is in the range of 10 to 300 µm.

(7) The spacer formation film according to the above feature (1), wherein the material constituting the spacer formation layer further contains a photo polymerizable resin.

(8) A semiconductor wafer to which the spacer formation film according to the above feature (1), which has been cut along the cutting line, is attached.

(9) A semiconductor device manufactured using the semiconductor wafer according to the above feature (8).

### BRIEF DESCRIPTION OF THE DRAWINGS

FIG. 1 is a sectional view showing one example of a semiconductor device.
FIG. 2 is a sectional view showing a preferred embodiment of a spacer formation film according to the present invention.
FIG. 3 is a top view showing the preferred embodiment of the spacer formation film according to the present invention.
FIG. 4 is a process chart showing one example of a method of manufacturing the semiconductor device.
FIG. 5 is a top view showing a bonding product obtained in a step of manufacturing the semiconductor device.

### BEST MODE FOR CARRYING OUT THE INVENTION

Hereinafter, description will be made on the present invention in detail.

### <Semiconductor device>

First, description will be made on a semiconductor device manufactured using a spacer formation film according to the present invention, prior to description of the spacer formation film according to the present invention.

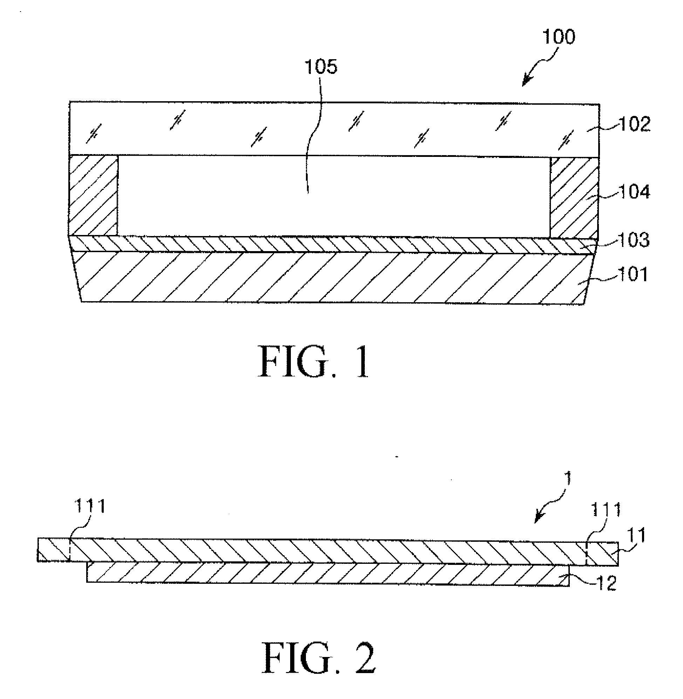

FIG. 1 is a sectional view showing one example of the semiconductor device (light receiving device) according to the present embodiment.
As shown in FIG. 1, a semiconductor device (light receiving device) 100 includes a base substrate 101, a transparent substrate 102, a light receiving portion 103 formed from a light receiving element, and a spacer 104 formed so as to surround the light receiving portion 103.

The base substrate 101 is a semiconductor substrate. On the base substrate 101, formed is, for example, a microlens array (not shown in the drawing).

The transparent substrate 102 is provided so as to face the base substrate 101 and has a planar size substantially equal to a planar size of the base substrate 101. For example, the transparent substrate 102 is an acryl resin substrate, a polyethylene terephthalate resin (PET) substrate, a glass substrate or the like.

The spacer 104 directly bonds the microlens array provided on the base substrate 101 to the transparent substrate 102, to thereby bond the base substrate 101 to the transparent substrate 102. And, this spacer 104 forms (defines) an air-gap potion 105 between the base substrate 101 and the transparent substrate 102.

Since this spacer 104 is provided so as to surround a central area of the microlens array provided on the base substrate 101, an area of the microlens array surrounded by the spacer 104 can substantially function as the light receiving potion 103.

A photoelectric conversion portion (not shown in the drawing) is formed on a lower surface of the light receiving portion 103, that is, on the base substrate 101, and thus changes light received by the light receiving portion 103 to electrical signals.

Further, in the light receiving portion 103, formed is a light receiving element such as CCD (Charge Coupled Device) or CMOS (Complementary Metal Oxide Semiconductor) .

In this regard, the semiconductor device to be manufactured using the spacer formation film according to the present invention is not limited to the above light receiving device, but can be used in a pressure sensor, an acceleration sensor, a printer head, a light scanner, a flow channel module or the like.

### <Spacer formation film>

Next, description will be made on a preferred embodiment of the spacer formation film according to the present invention.
The spacer formation film according to the present invention is used for forming the above spacer in manufacturing the semiconductor device as described above. Further, the spacer formation film according to the present invention is used by being cut into a desired shape, and then attached to one surface of the semiconductor wafer.

Hereinbelow, the description will be made on the preferred embodiment of the spacer formation film according to the present invention.

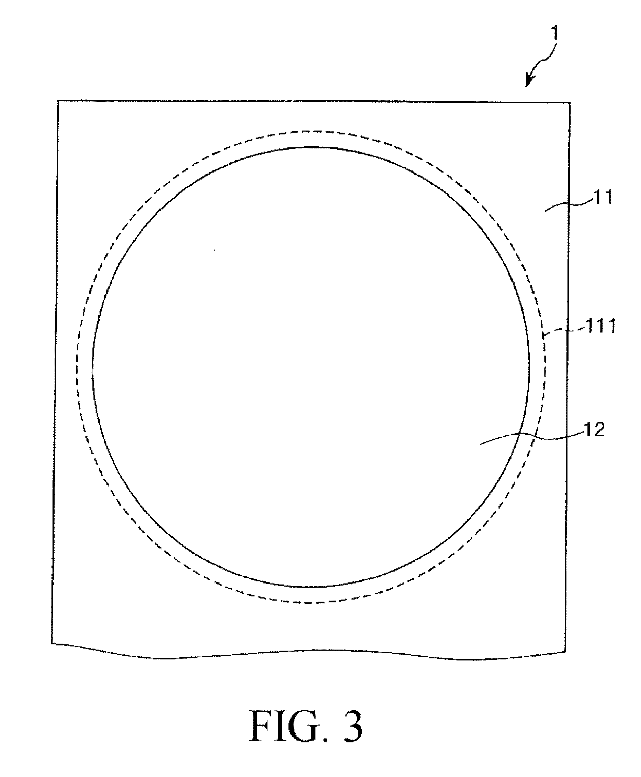

FIG. 2 is a sectional view showing the preferred embodiment of the spacer formation film according to the present invention, and FIG. 3 is a top view showing the preferred embodiment of the spacer formation film according to the present invention.

As shown in FIG. 2, the spacer formation film 1 includes a support base 11 and a spacer formation layer 12 provided on the support base 11. Further, the spacer formation film 1 also includes a cutting line 111 as shown in FIG. 2, and is used in manufacturing the semiconductor device 100 as described above after cutting it along the cutting line 111.

The support base 11 is a base (member) having a sheet-like shape and has a function for supporting the spacer formation layer 12.
This support base 11 is preferably formed of a material having optical transparency. By forming the support base 11 using such a material having optical transparency, exposure of the spacer formation layer 12 can be carried out through the support base 11 in manufacturing the semiconductor device as described below. This makes it possible to reliably expose the spacer formation layer 12 while effectively preventing undesired adhesion of foreign substances such as dust to the spacer formation layer 12 in manufacturing the semiconductor device. Further, this also makes it possible to prevent a mask to be used during expose from adhering to the spacer formation layer 12.

For example, examples of a material constituting such a support base 11 include polyethylene terephthalate (PET), polypropylene (PP), polyethylene (PE) and the like. Among them, it is preferable to use the polyethylene terephthalate (PET) from the viewpoint of having optical transparency and rupture strength in excellent balance.

The spacer formation layer 12 has a bonding property with respect to surfaces of the semiconductor wafer and a transparent substrate described below, and is a layer to be bonded to the semiconductor wafer and the transparent substrate. In this regard, in general, the semiconductor wafer is of a substantially circular shape, and has a so-called orientation flat or notch in order to indicate an orientation thereof.

In this embodiment, a planar shape of the spacer formation layer is a substantially circular shape as shown in FIG. 3.

Meanwhile, in a conventional photosensitive film, the bonding layer is provided on the entire surface of the sheet base. Therefore, in manufacturing the semiconductor device, a part of the bonding layer adheres to a blade used for cutting the film. The adhesive matters remaining on the blade are often transferred to the vicinity of a peripheral edge of the subsequent photosensitive film when cutting it. This causes adhesion of the adhesive matters on a surface of the photosensitive film when it is attached to the semiconductor wafer. In this case, the adhesive matters adhering on the surface prevent the bonding layer from being exposed during the exposure, and therefore the bonding layer cannot be patterned at sufficient accuracy. This causes a problem of lowering productivity of semiconductor devices.

In contrast, in the spacer formation film of the present invention, the spacer formation layer is provided inside the cutting line so that the peripheral edge thereof is not overlapped to the cutting line. Such a configuration of the spacer formation layer makes it possible to prevent a part of the bonding layer from adhering to the blade used for cutting it. As a result, in the case where semiconductor devices are consecutively manufactured, it is possible to prevent the adhesive matters from adhering to the surface of the spacer formation film, to thereby improve a patterning property during the exposure. Further, it is also possible to improve productivity of semiconductor devices. In this regard, it is to be noted that the cutting line means a predeterminate line adapted to be cut, that is, a so-called phantom cutting plane line along which the spacer formation film can be cut in a closed shape.

In this embodiment, as shown in FIG. 3, the cutting line 111 is set so as to surround the peripheral edge of the spacer formation layer. In other words, the cutting line 111 is of a substantially circular shape, and a circle defined by the cutting line 111 is concentrically arranged with respect to a circle defined by the peripheral edge of the spacer formation layer 12. Therefore, a diameter of the circle defined by the peripheral edge of the spacer formation layer 12 is smaller than a diameter of the circle defined by the cutting line.

The circle defined by the peripheral edge of the spacer formation layer 12 and the circle defined by the cutting line are provided so as to satisfy the following relation. Specifically, in the case where the diameter of the circle defined by the peripheral edge of the spacer formation layer 12 is "X (cm)" and the diameter of the circle defined by the cutting line 111 is "Y (cm)", X and Y satisfy preferably a relation of 0.800 X/Y <1.000, and more preferably a relation of 0.850 ≤ X/Y <1.000. By satisfying such a relation, it is possible to more reliably prevent a part of the spacer formation layer 12 from adhering to the blade to be used for cutting it. This makes it possible to make the patterning property more excellent during the exposure, to thereby further improve the productivity of semiconductor devices.

Further, in the case where the diameter of the circle defined by the cutting line 111 is "Y (cm)" and a diameter of the semiconductor wafer, to which the spacer formation layer is to be attached, is "Z (cm)", Y and Z satisfy preferably a relation of 0.85 ≤ Y/Z <1.15, and more preferably a relation of 0.90 ≤ Y/Z ≤1.10. If Y/Z is less than the above lower limit value, since an area of the spacer formation layer 12 to be attached to the semiconductor wafer becomes small, there is a case that the semiconductor wafer cannot be used for manufacturing the semiconductor devices sufficiently and effectively. On the other hand, if Y/Z exceeds the above upper limit value, there is a case that the spacer formation layer 12 is protruded between the semiconductor wafer and the spacer formation film 1 when the spacer formation film 1 attaches to the semiconductor wafer, and therefore a yield of the semiconductor devices is lowered.

Furthermore, in the case where the diameter of the circle defined by the peripheral edge of the spacer formation layer 12 is "X (cm)" and the diameter of the semiconductor wafer, to which the spacer formation layer is to be attached, is "Z (cm)", X and Z satisfy preferably a relation of 0.80 ≤ X/Z <1.00, and more preferably a relation of 0.85 ≤ X/Z <1.00. If X/Z is less than the above lower limit value, since an area of the spacer formation layer 12 to be attached to the semiconductor wafer becomes small, there is a case that the semiconductor wafer cannot be used for manufacturing the semiconductor devices sufficiently and effectively. On the other hand, if X/Z exceeds the above upper limit valuer there is a case that the spacer formation layer 12 climbs up an opposite surface of the semiconductor wafer or the transparent substrate to the spacer formation layer 12 when the transparent substrate is bonded to the semiconductor wafer, and therefore reliability of the semiconductor devices (light receiving devices) is lowered.

In the case where the spacer formation layer 12 is irradiated with light having all wavelengths using a mercury lamp so that an accumulated light intensity of i-beam (365 nm) becomes 700 mJ/cm², an elastic modulus thereof at 80°C is preferably 100 MPa or more, and more preferably in the range of 500 to 30,000 MPa. If the elastic modulus is less than the lower limit value, there is a case that a shape keeping property of the spacer formation layer 12 is lowered when the transparent substrate is bonded to the semiconductor wafer (base substrate). On the other hand, if the elastic modulus exceeds the upper limit value, there is a case that the transparent substrate is hardly bonded to the semiconductor wafer (base substrate) after the spacer formation layer 12 is exposed and developed.

Further, such a spacer formation layer 12 preferably satisfies the following requirement. Namely, an elastic modulus of the spacer formation layer 12, which is measured under the following conditions (1) to (3), is preferably 500 Pa or more, more preferably 1,000 Pa or more, and even more preferably 5,000 Pa or more. If the elastic modulus falls within the above range, it is possible to further improve the shape keeping property of the spacer of the semiconductor device. An upper limit value of the elastic modulus is not limited to a specific value, but is preferably 200,000 Pa or less, and more preferably 150,000 Pa or less. If the upper limit value of the elastic modulus exceeds the above range, there is a case that stress relaxation of the spacer is not sufficiently exhibited, and therefore the reliability of the semiconductor device is lowered.

(1) A thickness of the spacer formation layer is set to 100 µm.
(2) The spacer formation layer has been irradiated with an ultraviolet ray so that an accumulated light intensity thereof becomes 700 mJ/cm².
(3) A measuring temperature is set to 130°C.
Here, the elastic modulus can be measured using, for example, a dynamic viscoelasticity measuring machine ("Rheo Stress RS150" produced by HAAKE Companies). Specifically, a spacer formation layer 12 having a thickness of 50 µm is formed on a polyester film having a size of 250 mm × 200 mm, and then cut into a size of 30 mm × 30 mm, to thereby prepare 3 samples. Each sample is irradiated with a light using a mercury lamp so that the spacer formation layer 12 is photo-cured.
An accumulated light intensity of a light having a wavelength of 365 nm is set to 700 mJ/cm². Next, the photo-cured spacer formation layer 12 is removed from the polyester film, and then the 3 photo-cured spacer formation layers 12 are laminated together and fixed to the above dynamic viscoelasticity measuring machine. In this regard, a distance between cone-plates for fixing a sample is set to 100 µm, namely, the laminated photo-cured spacer formation layers 12 are pressed by shortening the distance between the plates so that a total thickness thereof becomes 100 µm. Further, measuring conditions are set to a frequency of 1 Hz, a temperature rising rate of 10°C/min and a temperature range of room temperature to 250°C.

Here, it is preferred that the elastic modulus is measured at a temperature that the transparent substrate is subjected to pressure bonding. Such a temperature is generally in the range of 80 to 180°C. Especially, in the case where an elastic modulus at 130°C, which is an average value of the above temperature range, falls within the above range, the present inventors have found that the shape keeping property of the spacer (resin spacer) is further improved.

Further, the reason why the thickness of the spacer formation layer 12 is set to 100 µm is as follows. It is preferred that an elastic modulus of a spacer formation layer 12 having the same thickness as the spacer formation layer 12 to be actually used is measured. However, in the case where the spacer formation layer 12 is thin, the result of the elastic modulus tends to vary. Therefore, a thickness of a spacer formation layer 12 whose elastic modulus is to be measured is set to 100 µm without exception.

In this regard, it is to be noted that the elastic modulus measured in the spacer formation layer 12 to be actually used becomes substantially equal to the elastic modulus measured in the above described spacer formation layer 12 having the thickness of 100 µm.

Furthermore, the reason why the spacer formation layer 12 is irradiated with the ultraviolet ray so that the accumulated light intensity thereof becomes 700 mJ/cm² is because the spacer formation layer 12 is sufficiently poto-cured. In this regard, in the case where the thickness of the spacer formation layer 12 varies, the accumulated light intensity is appropriately adjusted.

An average thickness of the spacer formation layer 12 is preferably in the range of 10 to 300 µm, and more preferably in the range of 15 to 250 µm. This makes it possible to manufacture a semiconductor device having a sufficient thin thickness, while maintaining sufficiently large sizes of the air-gap portions between the semiconductor wafer and the transparent substrate.

The above described spacer formation layer 12 is a layer having a photo curable property, an alkali developing property and a thermosetting property, and is formed of a material (resin composition) containing an alkali soluble resin, a thermosetting resin and a photo polymerization initiator.
Hereinbelow, description will be made on the resin composition constituting the spacer formation layer 12 in detail.

### (Alkali soluble resin)

The resin composition constituting the spacer formation layer 12 contains the alkali soluble resin. This makes it possible to have the alkali developable property to the spacer formation layer 12.

Examples of the alkali soluble resin include: a (meth)acryl-modified novolac resin such as a (meth)acryl-modified bis A novolac resin; an acryl resin; a copolymer of styrene and acrylic acid; a polymer of hydroxyl styrene; polyvinyl phenol; poly α-methyl vinyl phenol; and the like. Among them, an alkali soluble novolac resin is preferred, and the (meth)acryl-modified novolac resin is more preferred. This makes it possible to use an alkali solution having less adverse effect on environment instead of an organic solvent during the development of the spacer formation layer 12, and to maintain heat resistance thereof.

Further, an amount of the alkali soluble resin is not limited to a specific value, but is preferably in the range of about 50 to 95 wt% with respect to a total amount of the resin composition constituting the spacer formation layer 12. If the amount of the alkali soluble resin is less than the above lower limit value, there is a case that compatibility with other resins contained in the resin composition is lowered. On the other hand, if the amount of the alkali soluble resin exceeds the upper limit value, there is a case that a developing property and resolution of the resin composition are lowered.

### (Thermosetting resin)

The resin composition constituting the spacer formation layer 12 also contains the thermosetting resin. This makes it possible for the spacer formation layer 12 to exhibit a bonding property, even after being exposed and developed. Namely, the transparent substrate can be bonded to the spacer formation layer 12 by thermocompression bonding, after the spacer formation layer 12 has been attached to the semiconductor wafer, and exposed and developed.

Examples of the thermosetting resin include: a novolac-type phenol resin such as a phenol novolac resin, a cresol novolac resin and a bisphenol A novolac resin; a phenol resin such as a resol phenol resin; a bisphenol-type epoxy resin such as a bisphenol A epoxy resin and a bisphenol F epoxy resin; a novlolac-type epoxy resin such as a novolac epoxy resin and a cresol novolac epoxy resin; an epoxy resin such as a biphenyl-type epoxy resin, a stilbene-type epoxy resin, a triphenol methane-type epoxy resin, an alkyl-modified triphenol methane-type epoxy resin, a triazine chemical structure-containing epoxy resin and a dicyclopentadiene-modified phenol-type epoxy resin; an urea resin; a resin having triazine rings such as a melamine resin; an unsaturated polyester resin; a bismaleimide resin; a polyurethane resin; a diallyl phthalate resin; a silicone resin; a resin having benzooxazine rings; a cyanate ester resin; an epoxy-modified-siloxane; and the like. These thermosetting resins may be used singly or in combination of two or more of them.
Among them, it is preferable to use the epoxy resin. This makes it possible to improve heat resistance of the spacer formation layer 12 and adhesion of the transparent substrate thereto.

Further, it is preferred that both an epoxy resin in a solid form at room temperature (in particular, bisphenol-type epoxy resin) and an epoxy resin in a liquid form at room temperature (in particular, silicone-modified epoxy resin in a liquid form at room temperature) are used together as the epoxy resin. This makes it possible to obtain a spacer formation layer 12 having excellent flexibility and resolution, while maintaining heat resistance thereof.

An amount of the thermosetting resin is not limited to a specific value, but preferably in the range of about 10 to 40 wt%, and more preferably in the range of about 15 to 35 wt% with respect to the total amount of the resin composition constituting the spacer formation layer 12. If the amount of the thermosetting resin is less than the above lower limit value, there is a case that an effect of improving the heat resistance of the spacer formation layer 12 is lowered. On the other hand, if the amount of the thermosetting resin exceeds the above upper limit value, there is a case that an effect of improving toughness of the spacer formation layer 12 is lowered.

Further, it is preferred that the thermosetting resin further contains the phenol novolac resin in addition to the epoxy resin as described above. Addition of the phenol novolac resin makes it possible to improve the resolution of the spacer formation layer 12. Furthermore, in the case where the resin composition contains both the epoxy resin and the phenol novolac resin, it is also possible to further improve the thermosetting property of the epoxy resin, to thereby make strength of the spacer higher.

### (Photo polymerization initiator)

The resin composition constituting the spacer formation layer 12 also contains the photo polymerization initiator. This makes it possible to effectively pattern the spacer formation layer 12 through photo polymerization.

Examples of the photo polymerization initiator include benzophenone, acetophenone, benzoin, benzoin isobutyl ether, benzoin methyl benzoate, benzoin benzoic acid, benzoin methyl ether, benzyl phenyl sulfide, benzyl, dibenzyl, diacetyl, dibenzyl dimethyl ketal and the like.

An amount of the photo polymerization initiator is not limited to a specific value, but is preferably in the range of about 0.5 to 5 wt%, and more preferably in the range of about 0.8 to 3.0 wt% with respect to the total amount of the resin composition constituting the spacer formation layer 12. If the amount of the photo polymerization initiator is less than the above lower limit value, there is a fear that an effect of starting the photo polymerization is sufficiently obtained. On the other hand, if the amount of the photo polymerization initiator exceeds the above upper limit value, reactivity of the resin composition is increased, and therefore there is a fear that storage stability or resolution thereof is lowered.

### (Other components)

The resin composition constituting the spacer formation layer 12 may contain a photo polymerizable resin in addition to the above components.

As the photo polymerizable resin, for example, an acryl-based polyfunctional monomer is used. In the present specification, the polyfunctional monomer means a monomer containing three or more groups. Especially, in the present invention, it is more preferable to use an acrylic acid ester compound containing three or four groups. In the case of a monomer having two or less groups, there is a case that the thus formed spacer 104 cannot have excellent mechanical strength, to thereby keep the shape of the semiconductor device 100 sufficiently.

Concretely, examples of the acryl-based polyfunctional monomer include: a trifunctional (meth)acrylate such as trimethylol propane tri(meth)acrylate and pentaerythritol tri(meth)acrylate; a tetrafunctional (meth)acrylate such as pentaerythritol tetra(meth)acrylate and ditrimethylol propane tetra(meth)acrylate; a hexafunctional (meth)acrylate such as dipentaerythritol hexa(meth)acrylate; and the like. Among them, it is more preferable to use the trifunctional (meth) acrylate or the tetrafunctional (meth)acrylate. This makes it possible to impart more excellent mechanical strength to the spacer formation layer 12 after being exposed, to thereby further improve the shape keeping property thereof when bonding the transparent substrate to the semiconductor wafer.

In the case where the resin composition constituting the spacer formation layer 12 contains the acryl-based polyfunctional monomer, an amount thereof is preferably in the range of about 1 to 50 wt%, and more preferably in the range of about 5 to 25 wt% with respect to the total amount of the resin composition. This makes it possible to further enhance the mechanical strength of the spacer formation layer 12 after being exposed, to thereby effectively improve the shape keeping property thereof when bonding the transparent substrate to the semiconductor wafer.

The photo polymerizable resin may contain an epoxy vinyl ester resin. In this case, since it is reacted with the acryl-based polyfunctional monomer by radical polymerization, it is possible to more effectively improve the mechanical strength of the spacer 104 to be formed. On the other hand, it is possible to improve solubility of the spacer formation layer 12 with the alkali developer when developing it, to thereby reduce residues after the development.

Examples of the epoxy vinyl ester resin include 2-hydroxyl-3-phenoxypropyl acrylate, EPOLIGHT 40E methacryl addition product, EPOLIGHT 70P acrylic acid addition product, EPOLIGHT 200P acrylic acid addition product, EPOLIGHT 80MF acrylic acid addition product, EPOLIGHT 3002 methacrylic acid addition product, EPOLIGHT 3002 acrylic acid addition product, EPOLIGHT 1600 acrylic acid addition product, bisphenol A diglycidyl ether methacrylic acid addition product, bisphenol A diglycidyl ether acrylic acid addition product, EPOLIGHT 200E acrylic acid addition product, EPOLIGHT 400E acrylic acid addition product, and the like.

Further, in the case where the resin composition constituting the spacer formation layer 12 contains the epoxy vinyl ester resin, an amount thereof is not limited to a specific value, but is preferably in the range of about 3 to 30 wt%, and more preferably in the range of about 5 to 15 wt% with respect to the total amount of the resin composition. This makes it possible to more effectively reduce residues attached to each surface of the semiconductor wafer and transparent substrate after bonding them together.

In this regard, the resin composition constituting the spacer formation layer 12 may contain an inorganic filler. However, it is preferred that an amount thereof is 9 wt% or less with respect to the total amount of the resin composition. If the amount of the inorganic filler exceeds the above limit value, there is a case that foreign substances derived from the inorganic filler are attached onto the semiconductor wafer and undercut occur after developing the spacer formation layer 12. In this regard, in the case where the resin composition contains the above resin components, it may not contain the inorganic filler.

Examples of the inorganic filler include: a fibrous filler such as an alumina fiber and a glass fiber; a needle filler such as potassium titanate, wollastonite, aluminum borate, needle magnesium hydroxide and whisker; a platy filler such as talc, mica, sericite, a glass flake, scaly graphite and platy calcium carbonate; a globular (granular) filler such as calcium carbonate, silica, fused silica, baked clay and non-baked clay; a porous filler such as zeolite and silica gel; and the like. These inorganic fillers may be used singly or in combination of two or more of them. Among them, it is preferable to use the porous filler.

An average particle size of the inorganic filler is not limited to a specific value, but is preferably in the range of 0.01 to 90 µm, and more preferably in the range of 0.1 to 40 µm. If the average particle size exceeds the upper limit value, there is a case that appearance and resolution of the spacer formation layer 12 are lowered. On the other hand, if the average particle size is less than the above lower limit value, there is a case that the transparent substrate 102 cannot be reliably bonded to the spacer 104 even by the thermocompression bonding. In this regard, the average particle size is measured using, for example, a particle size distribution measurement apparatus of a laser diffraction type ("SALD-7000" produced by Shimadzu Corporation) .

A porous filler may be used as the inorganic filler. In the case where the porous filler is used as the inorganic filler, an average hole size of the porous filler is preferably in the range of about 0.1 to 5 nm, and more preferably in the range of about 0.3 to 1 nm.

The resin composition constituting the spacer formation layer 12 can also contain an additive agent such as a plastic resin, a labeling agent, a defoaming agent or a coupling agent in addition to the above components insofar as the purpose of the present invention is not spoiled.

Such a spacer formation film 1 may be produced by, for example, forming a coating film composed of the above resin composition onto the entire of a surface of the support base 11, specifying a region of the coating film to be converted into the spacer formation layer 12 inside the defined cutting line, and then removing a region other than the above region, or may be produced by applying the above resin composition onto the support base 11 inside the defined cutting line.

### <Method of manufacturing semiconductor device>

Next, description will be made on a preferred embodiment of the method of manufacturing the semiconductor device as described above with reference to the attached drawings.

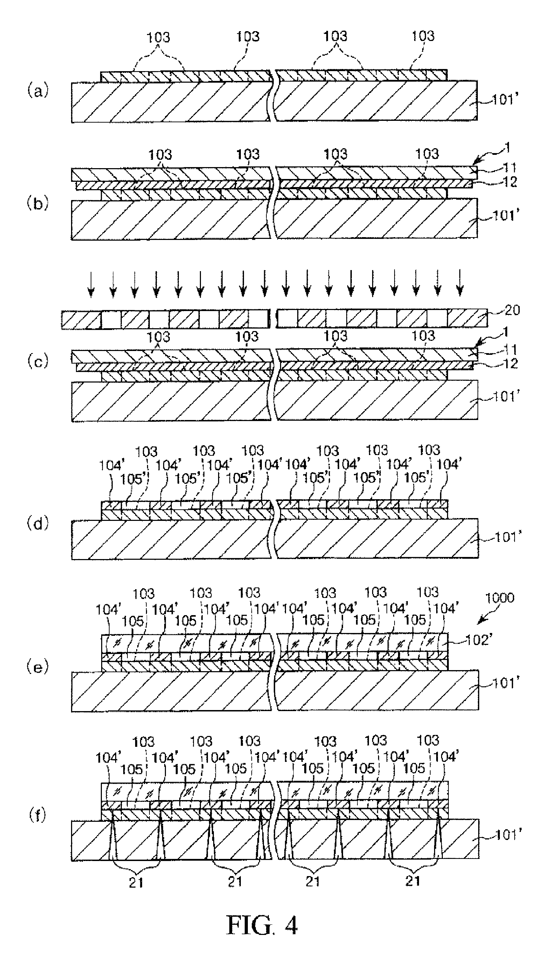

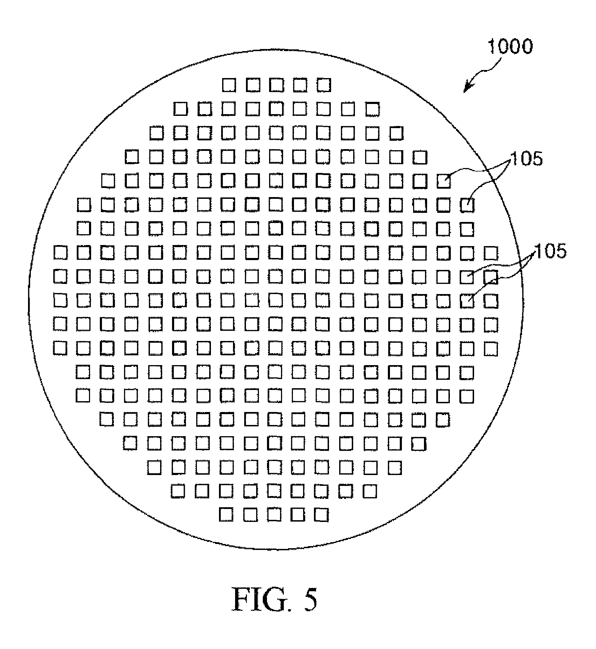

FIG. 4 is a process chart showing one example of a method of manufacturing the semiconductor device, and FIG. 5 is a top view showing a bonding product obtained in a step of manufacturing the semiconductor device.

First, the above described spacer formation film 1 according to the present invention is prepared, and then cut along the cutting line 111 shown in FIG. 3 using a cutting roll (this step is referred to as a cutting step). As described above, the spacer formation layer 12 is provided inside the cutting line 111 so that the peripheral edge of the spacer formation layer 12 is not overlapped to the cutting line 111. Therefore, since a part of the spacer formation layer 12, does not adhere to a blade of a cutter, in the case where another spacer formation film 1 is consecutively cut, a part of the spacer formation layer 12 is not transferred to a surface of another spacer formation film 1.

On the other hand, prepared is a semiconductor wafer 101' having a plurality of light receiving portions 103 and a microlens arrays (not shown in the drawings) formed on a functional surface thereof (see PIG 4(a)).

Next, as shown in FIG. 4(b), the spacer formation layer 12 (attaching surface) of the thus cut spacer formation film 1 is attached to the functional surface of the semiconductor wafer 101' (this step is referred to as a laminating step). This makes it possible to obtain a semiconductor wafer 101' to which the spacer formation film 1 cut along the cutting line is attached (semiconductor wafer of the present invention.

Next, the spacer formation layer 12 is irradiated with a light (ultraviolet ray) to expose it (this step is referred to as an exposing step).
At this time, as shown in FIG. 4(c), a region to be formed into the spacer is selectively irradiated with the light through a mask 20. In this way, the region of the spacer formation layer 12, which is irradiated with the light, is photo-cured.

Further, as shown in FIG. 4(c), the exposure of the spacer formation layer 12 is carried out through the support base 11. This makes it possible to reliably expose the spacer formation layer 12, while preventing undesired adhesion of dust to the spacer formation layer 12 effectively. Further, this also makes it possible to prevent for the mask 20 to adhere to the spacer formation layer 12 during the exposure.

Next, the support base 11 is removed, and then, as shown in FIG. 4(d), the spacer formation layer 12 is developed using an alkali aqueous solution. In this way, a non-cured region of the spacer formation layer 12 is removed so that the photo-cured region is remained as the spacer 104' (this step is referred to as a developing step). In other words, a plurality of regions 105' to be converted into the air-gap portions are formed between the semiconductor wafer and the transparent substrate.

Next, as shown in FIG. 4(e), the transparent substrate 102' is attached to an upper surface of the formed spacer 104', and then subjected to thermocompression bonding (this step is referred to as a thermocompression bonding step). In this way, the transparent substrate 102' is bonded to the semiconductor wafer 101', to thereby obtain a bonding product 1000 having the plurality of air-gap portions 105 between the semiconductor wafer 101' and the transparent substrate 102' (see FIG. 5).

The thermocompression bonding is preferably carried out within a temperature range of 80 to 180°C. This makes it possible to form the spacer 104 so as to have a favorable shape.

Thereafter, the obtained bonding product 1000 is diced so as to correspond to each light receiving portion unit (this step is referred to as a dicing step; see FIG. 4(f)). Specifically, first, grooves 21 are formed from a side of the semiconductor wafer 101' using a dicing saw. Next, a metal film (not shown in the drawing) is formed so as to cover inner surfaces of the grooves 21 and a surface of the semiconductor wafer 101' opposite to the transparent substrate 102' by spattering or the like. Thereafter, grooves 21 are also formed from a side of the transparent substrate 102' using the dicing saw, to thereby dice the bonding product 1000 so as to correspond to each light receiving portion unit.
Through the above steps, it is possible to obtain the semiconductor device 100 shown in FIG. 1.

The thus obtained semiconductor device 100 is mounted on, for example, a support substrate provided with a patterned wiring so that the wiring is electrically connected to a wiring (not shown in the drawing) formed on a lower surface of the base substrate 101 via solder bumps.

While the present invention has been described hereinabove with reference to the preferred embodiment, the present invention is not limited thereto.

For example, in the description of the above embodiment, the spacer formation film includes the support base and the spacer formation layer, but a configuration of the spacer formation film is not limited thereto. The spacer formation film of the present invention may further include a protective film for protecting a bonding surface of the spacer formation layer. A material constituting the protective film is not limited to a specific kind, as long as it has excellent rupture strength, flexibility and the like, and can exhibit a good peeling property with respect to the bonding surface. Examples of the material include polyethylene terephthalate (PET), polypropylene (PP) and polyethylene (PE). In this regard, it is to be noted that the protective film may be formed of an opaque material.

Further, in the description of the above embodiment, the shape of the cutting line and the shape of the peripheral edge of the bonding surface of the spacer formation film are the circular shapes, but the shapes are not limited thereto. In such a case, in a position where the peripheral edge of the bonding surface of the spacer formation layer is closest to the cutting line, a distance between the peripheral edge of the bonding surface of the spacer formation layer and the cutting line is preferably in the range of 10 to 20,000 µm, and more preferably in the range of 100 to 10,000 µm. This makes it possible to prevent a part of the spacer formation film from adhering to a blade to be used for cutting it. As a result, it is possible to further improve productivity of the semiconductor devices.

Furthermore, in the description of the above embodiment, the spacer formation film is exposed through the support base in manufacturing the semiconductor device, but may be exposed after removing the support base.

### EXAMPLES

Hereinafter, description will be made on the present invention based on the following Examples and Comparative Example, but the present invention is not limited thereto.

### [1] Production of spacer formation film

### (Example 1)

### 1. Synthesis of alkali soluble resin (methacryloyl-modified novolac-type bisphenol A resin)

500 g of a MEK (methyl ethyl ketone) solution containing a novolac-type bisphenol A resin ("Phenolite LF-4871" produced by DIC corporation) with a solid content of 60% was added into a 2L flask. Thereafter, 1.5 g of tributylamine as a catalyst and 0.15 g of hydroquinone as a polymerization inhibitor were added into the flask, and then they were heated at a temperature of 100°C. Next, 180.9 g of glycidyl methacrylate was further added into the flask in drop by drop for 30 minutes, and then they were reacted with each other by being stirred for 5 hours at 100°C, to thereby obtain a methacryloyl-modified novolac-type bisphenol A resin "MPN001" (methacryloyl modified ratio: 50%) with a solid content of 74%.

### 2. Preparation of resin varnish containing resin composition constituting spacer formation layer

15 wt% of trimethylol propane trimethacrylate ("LIGHT-ESTER TMP" produced by KYOEISHA CHEMICAL Co., LTD.) and 5 wt% of an epoxy vinyl ester resin ("EPOXYESTER 3002 methacrylic acid addition product" produced by KYOEISHA CHEMICAL Co., LTD) as a photo polymerizable resin; 5 wt% of cresol novolac-type epoxy resin ("EOCN-1020-70" produced by Nippon Kayaku Co., Ltd.), 10 wt% of a bisphenol A-type epoxy resin ("Ep-1001" produced by Japan Epoxy Resins Co., Ltd), 5 wt% of a silicone epoxy resin ("BY 16-115" produced by Dow Cornng Toray Co., Ltd) and 3 wt% of a phenol novolac resin ("PR 53647" produced by Sumitomo Bakelite Co., Ltd.) as a thermosetting resin; 55 wt% of the above methacryloyl-modified novolac-type bisphenol A resin (solid content) as an alkali soluble resin; and 2 wt% of a photo polymerization initiator ("IRGACURE 651" produced by Ciba Specialty Chemicals) were weighed, and stirred at a rotation speed of 3,000 rpm for 1 hour using a disperser, to prepare a resin varnish.

### 3. Production of spacer formation film

First, prepared was a polyester film having a thickness of 50 µm ("MRX 50" produced by Mitsubishi Plastics, Inc.) as a support base.

Next, the above prepared resin varnish was applied onto the polyester film as the support base using a konma coater ("model number: MGF No. 194001 type 3-293" produced by YASUI SEIKI) to form a coating film constituted from the resin varnish on the entire of a surface of the support base.

Next, a cutting line of a circular shape having a diameter of 20 cm was set on the support base, and then the coating layer was pre-cut using a die-cut system ("model number: DL-500W" produced by Fujishoko Corporation) so as to become a circular shape having a diameter of 18 cm in a planar view and concentrically arranged with respect to the circle defined by the cutting line. Thereafter, an inside portion of the coating film cut so as to become concentrically arranged with respect to the circle defined by the cutting line was left and an outside portion thereof was removed, to thereby obtain a pre-cut type spacer formation film. In the obtained spacer formation film, an average thickness of the spacer formation layer was 50 µm and a diameter of the cycle defined by the peripheral edge of the bonding surface of the spacer formation layer was 18 cm.

### (Examples 2 to 5)

The spacer formation film was produced in the same manner as Example 1, except that the diameter of the cycle defined by the set cutting line and the diameter of the cycle defined by the peripheral edge of the bonding surface of the spacer formation layer were changed to values shown in Table 1.

### (Examples 6 and 7)

The spacer formation film was produced in the same manner as Example 5, except that the mixing ratio of the respective components of the resin composition constituting the spacer formation layer was changed as shown in Table 1.

### (Comparative Example)

The spacer formation film was produced in the same manner as Example 1, except that the pre-cut was omitted.

In each of Examples and Comparative Example, shown are the kind and amount of each component of the resin composition constituting the spacer formation layer, the diameter of the cycle defined by the cutting line, the diameter of the cycle defined by the peripheral edge of the bonding surface of the spacer formation layer and the like in Table 1.
Further, in Table 1, indicated are the methacryloyl-modified novolac-type bisphenol A resin as "MPN", the trimethylol propane trimethacrylate as "TMP", the epoxy vinyl ester resin as "3002", the cresol novolac-type epoxy resin as "EOCN", the bisphenol A-type epoxy resin as "Ep", the silicone epoxy resin as "BY16" and the phenol novolac resin as "PR", respectively.

[Table 1]

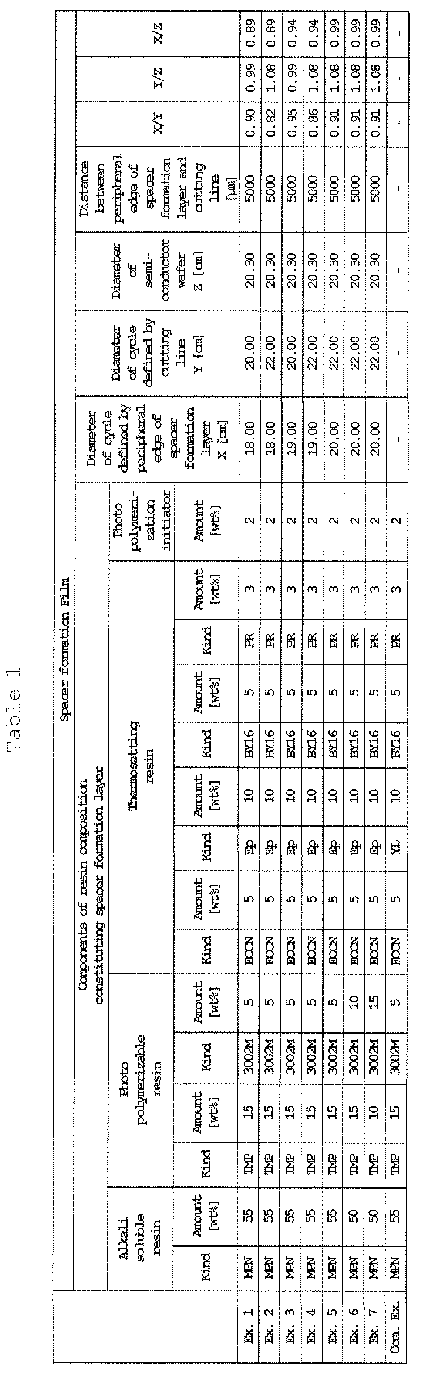

### [2] Evaluation of spacer formation film

### [2-1] Evaluation of patterning property by exposure

In each of Examples, the spacer formation film was consecutively cut according to the size shown in Table 1, to thereby obtain 50 pre-cut products.

Next, the 50 pre-cut products of the spacer formation film obtained in each of Examples were consecutively laminated on 8 inch-semiconductor wafers each having a diameter of 20.3 cm and a thickness of 725 µm ("product number: PW" produced by SUMCO CORPORATION) using a roll laminator under the conditions (roll temperature: 60°C; speed: 0.3 m/min; syringe pressure: 2.0 kgf/cm²), to thereby produce 50 semiconductor wafers with the pre-cut products of the spacer formation film.

On the other hand, the spacer formation film obtained in Comparative Example was consecutively pre-cut and laminated on semiconductor wafers using a fully automatic dry resist film laminating machine ("product number: TEAM-100RF" produced by Takatori Corporation), to thereby produce 50 semiconductor wafers with pre-cut products of the spacer formation film.

Next, the 50th 8 inch-semiconductor wafer with the pre-cut product of the spacer formation film, which was produced in each of Examples and Comparative Example, was exposed by being irradiated with a light having a wavelength of 365 nm through a mask so that an accumulated light intensity thereof became 700 mJ/cm², and then the support base was removed.

Next, the exposed spacer formation layer was developed using 2.38 wt% of tetramethyl ammonium hydro oxide (TMAH) aqueous solution at a developer pressure of 0.3 MPa for a developing time of 90 seconds, to thereby obtain a spacer having a width of 0.6 mm and areas to be formed into air-gap portions each having a size of 5 mm square.

A shape of the spacer obtained in each of Examples and Comparative Example was observed using an electron microscope (5,000 folds), and then a patterning property by exposure was evaluated based on the following evaluation criteria.
A: The spacer has no chips, thick parts or the like, and therefore has been patterned at high patterning accuracy.
B: The spacer slightly has chips, thick parts or the like, but has been patterned at such patterning accuracy as a problem does not practically occur.
C: The spacer has many chips, thick parts or the like, and therefore has not been patterned at sufficient patterning accuracy.
D: The spacer has defective parts, and therefore has been patterned at low patterning accuracy.

### [2-2] Evaluation of developing property

The spacer and the areas to be formed into air-gap portions of the semiconductor wafer obtained in the above evaluation [2-1] were observed using an electron microscope (500 folds), and then existence or nonexistence of residues was evaluated based on the following evaluation criteria.
A: No residues are observed at all, and thus the semiconductor wafer does not have a practical problem at all.
B: A few residues are observed, but the semiconductor wafer has a level that is not practically a problem.
C: Relatively many residues are observed, and thus the semiconductor wafer does not have a practical level.
D: Many residues are observed, and thus the semiconductor wafer does not have a practical level.
These results are shown in Table 2.

### [3] Manufacture of semiconductor device (light receiving device)

The 8 inch-semiconductor wafer having the spacer and the areas to be formed into air-gap portions, which was produced using the 1st pre-cut product of the spacer formation film obtained in each of Examples and Comparative Example in the above evaluation [2-1], and a 8 inch-transparent substrate were set to a substrate bonder ("SB8e" produced by Suss Microtec k.k.), and then they were pressure-bonded together and post-cured under the conditions of 150°C and 90 minutes, to thereby obtain a bonding product having the plurality of air-gap portions between the semiconductor wafer and the transparent substrate. The obtained bonding product was diced in predetermined sizes using a dicing saw, to obtain light receiving devices.

### (Reliability of light receiving device)

10 obtained light receiving devices were subjected to 1,000 cycles of a heat cycle test in which a treatment at -55°C for 1 hour and a treatment at 125°C for 1 hour were repeatedly performed, and then observation of cracks or peel-off was carried out and evaluated based on the following evaluation criteria.
A: No cracks and peel-off were observed in all the light receiving devices, and thus they do not have a practical problem at all.
B: A few cracks and peel-off were observed in two or less light receiving devices, but they do not have a practical problem.
C: Cracks and peel-off were observed in three or more light receiving devices, and thus they do not have a practical level.
D: Cracks and peel-off were observed in eight or more light receiving devices, and thus they do not have a practical level.
This result is also shown in Table 2 together with the above result.

[Table 2]

**Table 2**

| | Patterning property | Developing property | Reliability of semiconductor device |
|---|---|---|---|
| Ex. 1 | A | A | A |
| Ex. 2 | A | A | A |
| Ex. 3 | A | A | A |
| Ex. 4 | A | A | A |
| Ex. 5 | B | B | B |
| Ex. 6 | B | B | B |
| Ex. 7 | B | B | B |
| Com. Ex. | D | D | D |

As shown in Table 2, in the case where the spacer formation film of the present invention is used, the patterning property is not lowered, and therefore productivity of the semiconductor devices can be improve.

In contrast, in the case where the spacer formation film of Comparative Example is used, the patterning property by exposure is not sufficient. This is because a part of the spacer formation layer adheres to the blade of the cutter used for cutting the spacer formation film due to consecutive cutting, and the adhesive matters adhere to a spacer formation layer to be subsequently cut.

### INDUSTRIAL APPLICABILITY

According to the present invention, it is possible to obtain a spacer formation film having an excellent patterning property during exposure and superior productivity of semiconductor devices. Further, it is possible to provide a semiconductor wafer having excellent productivity of semiconductor devices and a semiconductor device manufactured using such a semiconductor wafer. Accordingly, the present invention has industrial applicability.

## Claims

1. A spacer formation film adapted to be used for forming a spacer defining air-gap portions on a side of one surface of a semiconductor wafer and by being cut into a desired shape, comprising:
a support base having a sheet-like shape;
a spacer formation layer provided on the support base and having a bonding property, the spacer formation layer formed of a material containing an alkali soluble resin, a thermosetting resin and a photo polymerization initiator; and
a cutting line along which the spacer formation film is to be cut,
wherein the spacer formation layer is provided inside the cutting line so that a peripheral edge thereof is not overlapped to the cutting line.

2. The spacer formation film as claimed in claim 1, wherein a planar shape of the spacer formation layer is a substantially circular shape having a diameter of "X",
wherein the cutting line is of a substantially circular shape having a diameter of "Y" and is concentrically arranged with respect to a circle defined by the peripheral edge of the spacer formation layer, and
wherein X and Y satisfy a relation of 0.80 ≤ X/Y <1.00.

3. The spacer formation film as claimed in claim 1, wherein the cutting line is of a substantially circular shape, and
wherein in the case where a diameter of a circle defined by the cutting line is "Y (cm)" and a diameter of the semiconductor wafer, to which the spacer formation layer is to be attached, is "Z (cm)", Y and Z satisfy a relation of 0.85 ≤ Y/Z ≤ 1.15.

4. The spacer formation film as claimed in claim 1, wherein a planar shape of the spacer formation layer is a substantially circular shape having a diameter of "X", and
wherein in the case where a diameter of the semiconductor wafer, to which the spacer formation layer is to be attached, is "Z (cm)", X and Z satisfy a relation of 0.80 ≤ X/Z <1.00.

5. The spacer formation film as claimed in claim 1, wherein in a position where the peripheral edge of the spacer formation layer is closest to the cutting line, a distance between the peripheral edge of the spacer formation layer and the cutting line is in the range of 10 to 20,000 µm.

6. The spacer formation film as claimed in claim 1, wherein an average thickness of the spacer formation layer is in the range of 10 to 300 µm.

7. The spacer formation film as claimed in claim 1, wherein the material constituting the spacer formation layer further contains a photo polymerizable resin.

8. A semiconductor wafer to which the spacer formation film defined by claim 1, which has been cut along the cutting line, is attached.

9. A semiconductor device manufactured using the semiconductor wafer defined by claim 8.
